# EUROPEAN PATENT APPLICATION

(11) **EP 1 933 426 A1**
(43) Date of publication of application: **18.06.2008**
(21) Application number: 06796961.8
(22) Date of filing: 29.08.2006
(51) Int. Cl.: H01R 33/76, H01R 13/24

(54) **CONTACT AND ELECTRICAL CONNECTOR**

(30) Priority: 07.10.2005 JP 2005295649
(71) Applicant: Tyco Electronics AMP K.K., Kawasaki-shi, Kanagawa-ken 213-8535 (JP)
(72) Inventor: HASHIMOTO, Shinichi, Kawasaki-shi, Kanagawa 2138535 (JP); SHIRAI, Hiroshi, Kawasaki-shi, Kanagawa 2138535 (JP)
(74) Representative: Johnstone, Douglas Ian
(86) International application number: PCT/JP2006/316984
(87) International publication number: WO 2007/043248

(57) **Abstract**

Provided are a contact, which improves contact reliability of a contact section of a first elastic contact arm which makes contact with a conductive pad of an IC package and reliability of a contact section of a second elastic contact arm which makes contact with a conductive pad of a circuit board, and an electrical connector. The contacts (30, 40) of the electrical connector (1) are provided with substantially rectangular substrate sections (31, 41), which are fixed in contact storing cavities (16, 17) of a housing (10) and extend in the vertical direction; connecting pieces (32, 42), which extend in a direction orthogonally intersecting main planes of the substrate sections (31, 41) from the substrate sections (31, 41); the first elastic contact arms (34, 44), which extend diagonally upward from leading ends of the connecting pieces (32, 42) and have contact sections (34c, 44c) making contact with the conductive pad of an IC package (PKG); and the second elastic contact arms (35, 45), which diagonally extend downward from leading ends of the connecting pieces (32, 42) and have contact sections (35c, 45c) making contact with the conductive pad of the circuit board (PCB).

## Description

### TECHNICAL FIELD

The present invention relates to a contact and an electrical connector for electrically connecting an IC package installed with an IC such as a DMD (digital micromirror device) to a circuit board.

### BACKGROUND ART

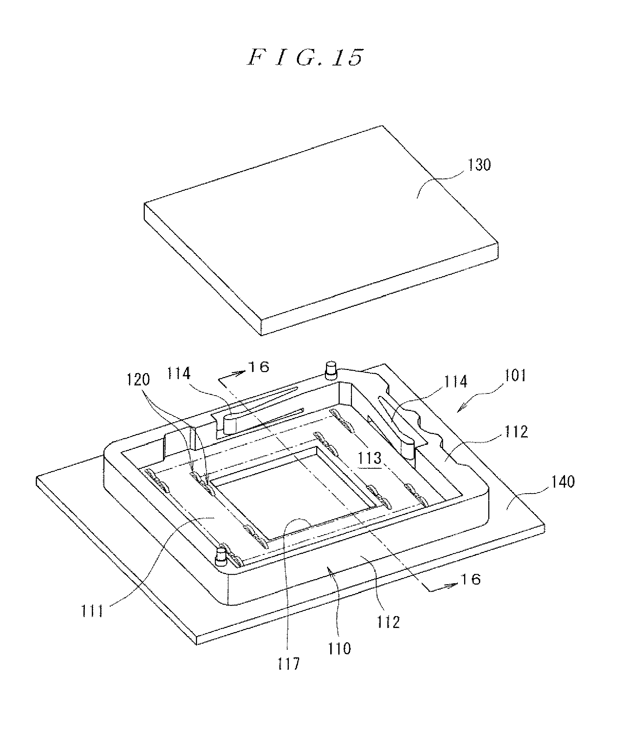

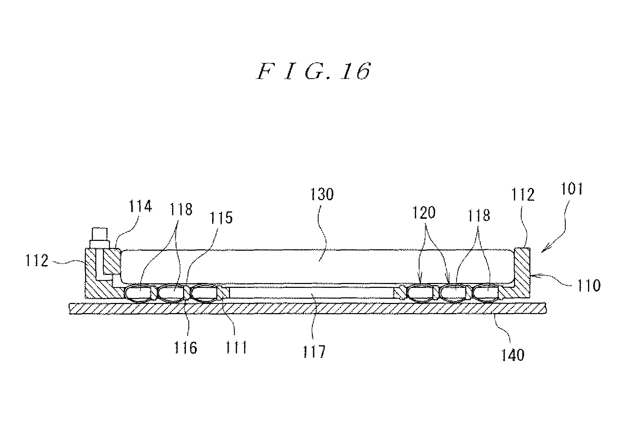

The electrical connector shown in FIGS. 15 and 16 (see JP 2005-174901A), for example, has been known in the past as an electrical connector for electrically connecting an IC package to a circuit board. FIG. 15 is a perspective view showing an electrical connector together with an IC package. FIG. 16 is a sectional view along line 16-16 in FIG. 15.
In FIGS. 15 and 16, the electrical connector 101 comprises an insulating housing 110 and a plurality of contacts 120 secured to the housing 110.

The housing 110 comprises a substantially rectangular plate-form base part 111 that is mounted on a circuit board 140 and side walls 112 consisting of four sides rising from the edges of the base part 111. A rectangular opening 117 is formed in the central portion of the base part 111, and a plurality of contact accommodating cavities 118 are arranged in the form of a matrix so as to surround the opening 117. Furthermore, the space surrounded by the side walls 112 consisting of four sides and the base part 111 forms a package accommodating space 113 that accommodates an IC package 130. Moreover, elastic arms 114 are provided on two adjacent side walls 112 out of the four side walls 112.

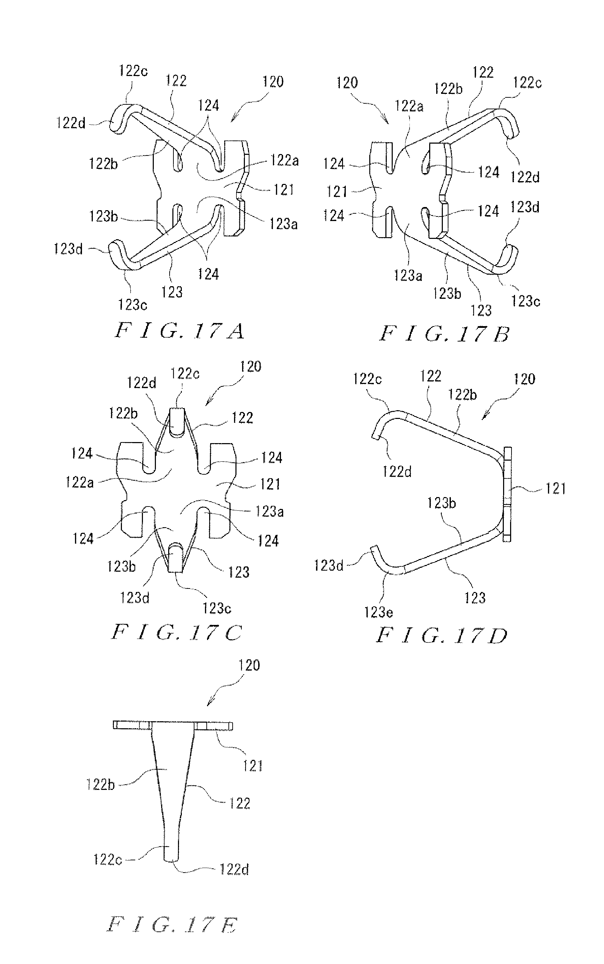

FIGS. 17A, 17B, 17C, 17D, and 17E show a contact; FIG. 17A is a perspective view as seen from the front at an inclination toward the right side, FIG. 17B is a perspective view as seen from the back at an inclination toward the right side, FIG. 17C is a front view, FIG. 17D is a right side view, and FIG. 17E is a plan view.
As is shown in FIGS. 17A, 17B, 17C, 17D, and 17E, each contact 120 comprises a base plate part 121 that is formed in a substantially rectangular plate form, a first elastic contact arm 122 that extends upward from the base plate part 121, and a second elastic contact arm 123 that extends downward from the base plate part 121; each contact 120 is formed by stamping and forming a metal plate. Here, the base plate part 121 is designed such that both left and right side edges thereof are press-fitted into one of the contact accommodating cavities 118 in the housing 110.

The first elastic contact arm 122 is formed in a cantilever shape comprising a base part 122a that extends from the central portion in the direction of width of the upper edge of the base plate part 121, an arm part 122b that extends forward at an inclination toward the top from the upper end of the base part 122a with the width thereof being gradually reduced toward the tip end, a contact part 122c that is formed by bending at the tip end of the arm part 122b, and a tip end part 122d that extends forward at an inclination toward the bottom from the contact part 122c. A pair of cutouts 124 for allowing the first elastic contact arm 122 to flex easily in the vertical direction are formed in either side of the base part 122a in the direction of width. Furthermore, in a state in which the base plate part 121 is press-fitted into a contact accommodating cavity 118 in the housing 110, the arm part 122b, contact part 122c, and tip end part 122d of the first elastic contact arm 122 are designed to protrude upward from the upper surface of the base part 111 of the housing 110. Moreover, when the IC package 130 is accommodated in the package accommodating space 113, a conductive pad (not shown in the figures) provided on the undersurface of the IC package 130 contacts the contact part 122c from above.

In addition, the second elastic contact arm 123 is formed in a shape symmetrical to the first elastic contact arm 122, and is formed in a cantilever shape comprising a base part 123a that extends from the central portion in the direction of width of the lower edge of the base plate part 121, an arm part 123b that extends forward at an inclination toward the bottom from the lower end of the base part 123a with the width thereof being gradually reduced toward the tip end, a contact part 123c that is formed by bending at the tip end of the arm part 123b, and a tip end part 123d that extends forward at an inclination toward the top from the contact part 123c. A pair of cutouts 124 for allowing the second elastic contact arm 123 to flex easily in the vertical direction are formed in either side of the base part 123a in the direction of width. Furthermore, in a state in which the base plate part 121 is press-fitted into a contact accommodating cavity 118 in the housing 110, the arm part 123b, contact part 123c, and tip end part 123d of the second elastic contact arm 123 are designed to protrude downward from the undersurface of the base part 111 of the housing 110. Moreover, when the connector 101 is mounted on the circuit board 140, a conductive pad (not shown in the figures) provided on the upper surface of the circuit board 140 contacts the contact part 123c from below.

Here, when the IC package 130 is accommodated in the package accommodating space 113 from above, sides of the IC package 130 press the elastic arms 114 provided on side walls 112, and cause these elastic arms 114 to be elastically deformed and move toward these side walls 112, so that the IC package 130 is prevented from slipping out of the package accommodating space 113 by the elastic force of these elastic arms 114. In this case, furthermore, the conductive pads (not shown in the figures) provided on the IC package 130 contact the contact parts 122c, and the conductive pads (not shown in the figures) provided on the circuit board 140 contact the contact parts 123c; moreover, the conductive pads of the IC package 130 press the contact parts 122c, and the conductive pads of the circuit board 140 press the contact parts 123c, so that the first elastic contact arms 122 and second elastic contact arms 123 of the contacts 120 flex, and respectively undergo elastic displacement in the vertical direction so as to approach each other, thus realizing the secure electrical connection between the IC package 130 and the circuit board 140. Furthermore, when the first elastic contact arms 122 and second elastic contact arms 123 of the contacts 120 flex, and respectively undergo elastic displacement in the vertical direction so as to approach each other, the contact pressure against the contact parts 122c and the contact pressure against the contact parts 123c are respectively imparted by the elastic forces of these first elastic contact arms 122 and second elastic contact arms 123, thus obtaining the contact reliability of these contact parts 122c and 123c.

Moreover, when the conductive pads (not shown in the figures) provided on the IC package 130 contact and press the contact parts 122c, and the conductive pads (not shown in the figures) provided on the circuit board 140 contact and press the contact parts 123c, the respective first elastic contact arms 122 and second elastic contact arms 123 are elastically displaced in the horizontal direction as well, so that the contact parts 122c and contact parts 123c horizontally move toward adjacent contacts 120. In this case, between two contact accommodating cavities 118, a first projection 115 is disposed on the upper side, and a second projection 116 is disposed on the lower side; accordingly, when the contact parts 122c and contact parts 123c reach certain positions, the free ends of the first elastic contact arms 122 contact the side surfaces of the first projections 115, and the free ends of the second elastic contact arms 123 contact the side surfaces of the second projections 116, so that it is possible to prevent the plastic deformation of the first elastic contact arms 122 and second elastic contact arms 123 caused by the application of an excessive force.

### DISCLOSURE OF THE INVENTION

However, the following problems have been encountered in such a conventional electrical connector 101:
Specifically, there are cases in which the IC package 130 or circuit board 140 is warped or deformed for some reason. In such cases, when the conductive pads provided on the IC package 130 contact and press the contact parts 122c, and the conductive pads provided on the circuit board 140 contact and press the contact parts 123c, it is not possible to obtain a desired amount of flexing of the first elastic contact arms 122 and second elastic contact arms 123 of the contacts 120 in the vertical direction. As a result, a desired elastic force of these first elastic contact arms 122 and second elastic contact arms 123 cannot be obtained, which makes it impossible to give the appropriate contact pressure against the contact parts 122c and the appropriate contact pressure against the contact parts 123c, so that the contact reliability of these contact parts 122c and 123c may be insufficient.

Accordingly, the present invention was devised in light of these problems; it is an object of the present invention to provide a contact and an electrical connector which can increase the contact reliability of the contact parts of the first elastic contact arms that contact the conductive pads on an IC package and the contact parts of the second elastic contact arms that contact the conductive pads on a circuit board.
In order to solve the problems described above, the contact of Claim 1 is a contact comprising: a substantially rectangular base plate part that extends in the vertical direction and that is secured to a contact accommodating cavity in a housing; a linking part that extends from the base plate part in a direction intersecting with the main surface of the base plate part; a first elastic contact arm that extends obliquely upward from the tip end of the linking part and that has a contact part which contacts a conductive pad on an IC package; and a second elastic contact arm that extends obliquely downward from the tip end of the linking part and that has a contact part which contacts a conductive pad on a circuit board.

Furthermore, the contact of Claim 2 is the contact according to Claim 1, wherein bevels are applied to the corner portions of the two side surfaces of the contact part of the first elastic contact arm and/or the corner portions of the two side surfaces of the contact part of the second elastic contact arm.
Moreover, the contact of Claim 3 is the contact according to Claim 1 or 2, wherein an anti-slipping piece that prevents the tip end of the contact part from slipping out of the contact accommodating cavity by contacting the housing is provided at the tip end of the contact part of the first elastic contact arm and/or the contact part of the second elastic contact arm.

In addition, the electrical connector of Claim 4 is an electrical connector comprising:
a housing in which a plurality of first contact accommodating cavities and a plurality of second contact accommodating cavities are disposed in a staggered arrangement such that the base plate part accommodating parts of the first contact accommodating cavities and the base plate part accommodating parts of the second contact accommodating cavities are aligned in a straight line;
a plurality of first contacts each of which comprises a substantially rectangular base plate part that extends in the vertical direction and that is secured to the base plate part accommodating part of one of the first contact accommodating cavities, a linking part that extends from the base plate part in a direction intersecting with the main surface of the base plate part, a first elastic contact arm that extends obliquely upward from the tip end of this linking part and that has a contact part which contacts a conductive pad on an IC package, and a second elastic contact arm that extends obliquely downward from the tip end of the linking part and that has a contact part which contacts a conductive pad on a circuit board; and a plurality of second contacts each of which comprises a substantially rectangular base plate part that extends in the vertical direction and that is secured to the base plate part accommodating part of one of the second contact accommodating cavities, a linking part that extends from this base plate part in the direction opposite from the direction intersecting with the main surface of the base plate part of a first contact, a first elastic contact arm that extends obliquely upward from the tip end of this linking part and that has a contact part which contacts a conductive pad on the IC package, and a second elastic contact arm that extends obliquely downward from the tip end of the linking part and that has a contact part which contacts a conductive pad on the circuit board.

Furthermore, the electrical connector of Claim 5 is the electrical connector according to Claim 4, wherein bevels are respectively applied to the corner portions of the two side surfaces of the contact parts of the first elastic contact arms and/or the corner portions of the two side surfaces of the contact parts of the second elastic contact arms of the first contacts, and bevels are respectively applied to the corner portions of the two side surfaces of the contact parts of the first elastic contact arms and/or the corner portions of the two side surfaces of the contact parts of the second elastic contact arms of the second contacts.
Moreover, the electrical connector of Claim 6 is the electrical connector according to Claim 4 or 5, wherein anti-slipping pieces are respectively provided at the tip ends of the contact parts of the first elastic contact arms and/or the contact parts of the second elastic contact arms of the first contacts, with these anti-slipping pieces preventing these tip ends from slipping out of the first contact accommodating cavities by contacting the housing, and anti-slipping pieces are respectively provided at the tip ends of the contact parts of the first elastic contact arms and/or the contact parts of the second elastic contact arms of the second contacts, with these anti-slipping pieces preventing these tip ends from slipping out of the second contact accommodating cavities by contacting the housing.

The contact of Claim 1 comprises a substantially rectangular base plate part that extends in the vertical direction and that is secured to a contact accommodating cavity in a housing; a linking part that extends from the base plate part in a direction intersecting with the main surface of the base plate part; a first elastic contact arm that extends obliquely upward from the tip end of the linking part and that has a contact part which contacts a conductive pad on an IC package; and a second elastic contact arm that extends obliquely downward from the tip end of the linking part and that has a contact part which contacts a conductive pad on a circuit board. Therefore, even in cases where the IC package or circuit board is warped or deformed for some reason, when a conductive pad provided on the IC package contacts and presses the contact part of the first elastic contact arm, and a conductive pad provided on the circuit board contacts and presses the contact part of the second elastic contact arm, the linking part that is linked to the first elastic contact arm and second elastic contact arm is elastically deformed with forces smaller than these pressing forces, so that the pressing force applied to the contact part on one side is transmitted to the contact part on the other side. Accordingly, it is possible to obtain desired amounts of flexing of the first elastic contact arm and second elastic contact arm in the vertical direction; as a result, it is possible to obtain desired elastic forces of the first elastic contact arm and second elastic contact arm, which respectively impart the appropriate contact pressure against the contact part of the first elastic contact arm and the appropriate contact pressure against the contact part of the second elastic contact arm. Consequently, it is possible to increase the contact reliability of the contact part of the first elastic contact arm that contacts a conductive pad on the IC package and the contact part of the second elastic contact arm that contacts a conductive pad on the circuit board.

In the contact of Claim 2, furthermore, bevels are applied to the corner portions of the two side surfaces of the contact part of the first elastic contact arm and/or the corner portions of the two side surfaces of the contact part of the second elastic contact arm in the contact according to Claim 1. Accordingly, there is a case in which bevels are applied only to the corner portions of the two side surfaces of the contact part of the first elastic contact arm, a case in which bevels are applied only to the corner portions of the two side surfaces of the contact part of the second elastic contact arm, and a case in which bevels are applied to both the corner portions of the two side surfaces of the contact part of the first elastic contact arm and the corner portions of the two side surfaces of the contact part of the second elastic contact arm. In the case of applying bevels only to the corner portions of the two side surfaces of the contact part of the first elastic contact arm, in cases where the IC package is rotated or slid, causing an external force to be applied to the contact part of the first elastic contact arm from a conductive pad provided on the IC package when this conductive pad contacts the contact part, the beveled portions applied to the corner portions of the two side surfaces of the contact part of the first elastic contact arm can prevent this contact part and conductive pad from catching each other. The conductive pad protrudes slightly from the main surface of the IC package, and therefore tends to be caught by the contact part of the first elastic contact arm of the contact. Moreover, in the case of applying bevels only to the corner portions of the two side surfaces of the contact part of the second elastic contact arm, in cases where the circuit board is rotated or slid, causing an external force to be applied to the contact part of the second elastic contact arm from a conductive pad provided on the circuit board when this conductive pad contacts the contact part, the beveled portions applied to the corner portions of the two side surfaces of the contact part of the second elastic contact arm can prevent this contact part and conductive pad from catching each other. The conductive pad protrudes slightly from the main surface of the circuit board, and therefore tends to be caught by the contact part of the second elastic contact arm of the contact. In addition, in the case of applying bevels to both the corner portions of the two side surfaces of the contact part of the first elastic contact arm and the corner portions of the two side surfaces of the contact part of the second elastic contact arm, in cases where the IC package is rotated or slid, causing an external force to be applied to the contact part of the first elastic contact arm from a conductive pad provided on the IC package when this conductive pad contacts the contact part, the beveled portions applied to the corner portions of the two side surfaces of the contact part of the first elastic contact arm can prevent this contact part and conductive pad from catching each other. Likewise, in cases where the circuit board is rotated or slid, causing an external force to be applied to the contact part of the second elastic contact arm from a conductive pad provided on the circuit board when this conductive pad contacts the contact part, the beveled portions applied to the corner portions of the two side surfaces of the contact part of the second elastic contact arm can prevent this contact part and conductive pad from catching each other.

Moreover, in the contact of Claim 3, an anti-slipping piece that prevents the tip end of the contact part from slipping out of the contact accommodating cavity by contacting the housing is provided at the tip end of the contact part of the first elastic contact arm and/or the contact part of the second elastic contact arm in the contact according to Claim 1 or 2. Accordingly, there is a case in which an anti-slipping piece is provided only at the tip end of the contact part of the first elastic contact arm, a case in which an anti-slipping piece is provided only at the tip end of the contact part of the second elastic contact arm, and a case in which anti-slipping pieces are provided both at the tip end of the contact part of the first elastic contact arm and at the tip end of the contact part of the second elastic contact arm. In the case of providing an anti-slipping piece only at the tip end of the contact part of the first elastic contact arm, even in cases where the IC package is rotated or slid, causing an external force to be applied to the contact part of the first elastic contact arm from a conductive pad provided on the IC package when this conductive pad contacts the contact part, the anti-slipping piece contacts the housing, so that the tip end of this contact part can be prevented from slipping out of the contact accommodating cavity, and the deformation of the first elastic contact arm can be prevented. Furthermore, in the case of providing an anti-slipping piece only at the tip end of the contact part of the second elastic contact arm, even in cases where the circuit board is rotated or slid, causing an external force to be applied to the contact part of the second elastic contact arm from a conductive pad provided on the circuit board when this conductive pad contacts the contact part, the anti-slipping piece contacts the housing, so that the tip end of this contact part can be prevented from slipping out of the contact accommodating cavity, and the deformation of the second elastic contact arm can be prevented. In addition, in the case of providing anti-slipping pieces both at the tip end of the contact part of the first elastic contact arm and at the tip end of the contact part of the second elastic contact arm, in cases where the IC package is rotated or slid, causing an external force to be applied to the contact part of the first elastic contact arm from a conductive pad provided on the IC package when this conductive pad contacts the contact part, the anti-slipping piece contacts the housing, so that the tip end of this contact part can be prevented from slipping out of the contact accommodating cavity, and the deformation of the first elastic contact arm can be prevented. Likewise, in cases where the circuit board is rotated or slid, causing an external force to be applied to the contact part of the second elastic contact arm from a conductive pad provided on the circuit board when this conductive pad contacts the contact part, the anti-slipping piece contacts the housing, so that the tip end of this contact part can be prevented from slipping out of the contact accommodating cavity, and the deformation of the second elastic contact arm can be prevented.

In addition, the electrical connector of Claim 4 makes it possible to increase the contact reliability of the contact parts of the first elastic contact arms of the first contacts and second contacts that contact the conductive pads on the IC package, and to increase the contact reliability of the contact parts of the second elastic contact arms of the first contacts and second contacts that contact the conductive pads on the circuit board. Furthermore, a housing is provided in which a plurality of first contact accommodating cavities and a plurality of second contact accommodating cavities are disposed in a staggered arrangement such that the base plate part accommodating parts of the first contact accommodating cavities and the base plate part accommodating parts of the second contact accommodating cavities are aligned in a straight line. Moreover, each of the first contacts comprises a base plate part that is fastened to the base plate part accommodating part of one of the first contact accommodating cavities, a linking part that extends from the base plate part in a direction intersecting with the main surface of the base plate part, and a first elastic contact arm and a second elastic contact arm that are provided at the tip end of this linking part, while each of the second contacts comprises a base plate part that is fastened to the base plate part accommodating part of one of the second contact accommodating cavities, a linking part that extends from this base plate part in the direction opposite from the direction intersecting with the main surface of the base plate part of a first contact, and a first elastic contact arm and a second elastic contact arm that are provided at the tip end of this linking part. Therefore, in a state in which the base plate parts of the first contacts and the base plate parts of the second contacts are linked to a carrier, the base plate parts of the first contacts and the base plate parts of the second contacts can be respectively inserted and press-fitted into the base plate part accommodating parts of the first contact accommodating cavities and the base plate part accommodating parts of the second contact accommodating cavities all at once. Accordingly, the press-fitting work of the contacts can be facilitated. Furthermore, when the base plate parts of the first contacts and the base plate parts of the second contacts are respectively press-fitted into the base plate part accommodating parts of the first contact accommodating cavities and the base plate part accommodating parts of the second contact accommodating cavities, the first elastic contact arms and second elastic contact arms of the first contacts and the first elastic contact arms and second elastic contact arms of the second contacts are respectively disposed in a staggered arrangement. Moreover, because the linking parts of the first contacts and the linking parts of the second contacts respectively extend in opposite directions relative to each other from the base plate parts, the first elastic contact arms and second elastic contact arms of the first contacts and the first elastic contact arms and second elastic contact arms of the second contacts can be arranged in a staggered fashion with respect to the carrier, so that the material for the first contacts and second contacts can be obtained in a favorable manner.

Furthermore, in the electrical connector of Claim 5, bevels are respectively applied to the corner portions of the two side surfaces of the contact parts of the first elastic contact arms and/or the corner portions of the two side surfaces of the contact parts of the second elastic contact arms of the first contacts, and bevels are respectively applied to the corner portions of the two side surfaces of the contact parts of the first elastic contact arms and/or the corner portions of the two side surfaces of the contact parts of the second elastic contact arms of the second contacts in the electrical connector according to Claim 4. Accordingly, in the first contacts, there is a case in which bevels are applied only to the corner portions of the two side surfaces of the contact parts of the first elastic contact arms, a case in which bevels are applied only to the corner portions of the two side surfaces of the contact parts of the second elastic contact arms, and a case in which bevels are applied to both the corner portions of the two side surfaces of the contact parts of the first elastic contact arms and the corner portions of the two side surfaces of the contact parts of the second elastic contact arms, and in the second contacts, there is a case in which bevels are applied only to the corner portions of the two side surfaces of the contact parts of the first elastic contact arms, a case in which bevels are applied only to the corner portions of the two side surfaces of the contact parts of the second elastic contact arms, and a case in which bevels are applied to both the corner portions of the two side surfaces of the contact parts of the first elastic contact arms and the corner portions of the two side surfaces of the contact parts of the second elastic contact arms. In these cases, it is possible to obtain the same effects as those of the contact of Claim 2.

Moreover, in the electrical connector of Claim 6, anti-slipping pieces are respectively provided at the tip ends of the contact parts of the first elastic contact arms and/or the contact parts of the second elastic contact arms of the first contacts, with these anti-slipping pieces preventing these tip ends from slipping out of the first contact accommodating cavities by contacting the housing, and anti-slipping pieces are respectively provided at the tip ends of the contact parts of the first elastic contact arms and/or the contact parts of the second elastic contact arms of the second contacts, with these anti-slipping pieces preventing these tip ends from slipping out of the second contact accommodating cavities by contacting the housing in the electrical connector according to Claim 4 or 5. Accordingly, in the first contacts, there is a case in which anti-slipping pieces are respectively provided only at the tip ends of the contact parts of the first elastic contact arms, a case in which anti-slipping pieces are respectively provided only at the tip ends of the contact parts of the second elastic contact arms, and a case in which anti-slipping pieces are respectively provided both at the tip ends of the contact parts of the first elastic contact arms and at the tip ends of the contact parts of the second elastic contact arms, and in the second contacts, there is a case in which anti-slipping pieces are respectively provided only at the tip ends of the contact parts of the first elastic contact arms, a case in which anti-slipping pieces are respectively provided only at the tip ends of the contact parts of the second elastic contact arms, and a case in which anti-slipping pieces are respectively provided both at the tip ends of the contact parts of the first elastic contact arms and at the tip ends of the contact parts of the second elastic contact arms. In these cases, it is possible to obtain the same effects as those of the contact of Claim 3.

### BRIEF DESCRIPTION OF THE DRAWINGS

FIG. 1 is a plan view of the electrical connector of the present invention; here, an IC package is also shown by a one-dot chain line;
FIG. 2 is a front view of the electrical connector of FIG. 1;
FIG. 3 is a bottom view of the electrical connector of FIG. 1;
FIG. 4 is a plan view showing a portion of a contact accommodating cavity row in FIG. 1;
FIG. 5 is a sectional view along line 5-5 in FIG. 1;
FIG. 6 is a bottom view showing a portion of a contact accommodating cavity row in FIG. 3;
FIGS. 7A, 7B, 7C, 7D, 7E, and 7F show a first contact, with FIG. 7A being a front view, FIG. 7B being a right side view, FIG. 7C being a left side view, FIG. 7D being a back view, FIG. 7E being a plan view, and FIG. 7F being a bottom view;
FIG. 8 is an explanatory diagram showing the action of a first elastic contact arm and a second elastic contact arm in a case in which an external force is applied to the first elastic contact arm of a first contact;
FIGS. 9A and 9B show a state in which the first contacts and second contacts are attached to a carrier, with FIG. 9A being a plan view of first contacts and a second contact, and FIG. 9B being a side view of the first contacts and second contact;
FIGS. 10A and 10B show a state in which the first contacts are attached to the carrier in a case in which the first contacts are arranged in a staggered fashion using only the first contacts, with FIG. 10A being a plan view of first contacts, and FIG. 10B being a side view of the first contacts;
FIG. 11 is a plan view showing a portion of a contact accommodating cavity row in a case in which the first contacts are arranged in a staggered fashion using only the first contacts shown in FIGS. 10A and 10B;
FIG. 12 is a perspective view used to illustrate a method for mounting an electrical connector accommodating an IC package in the housing of an optical engine;
FIG. 13 is a perspective view used to illustrate a method for attaching a jig to a circuit board;
FIG. 14 is a perspective view used to illustrate a method for mounting the circuit board on the housing of the optical engine using the jig attached to the circuit board;
FIG. 15 is a perspective view showing a conventional electrical connector together with an IC package;
FIG. 16 is a sectional view along line 16-16 in FIG. 15; and
FIGS. 17A, 17B, 17C, 17D, and 17E show a contact used in the electrical connector of FIG. 15, with FIG. 17A being a perspective view as seen from the front at an inclination toward the right side, FIG. 17B being a perspective view as seen from the back at an inclination toward the right side, FIG. 17C being a front view, FIG. 17D being a right side view, and FIG. 17E being a plan view.

### Explanation of Symbols

- 1:: Electrical connector
- 16:: First contact accommodating cavity
- 16a:: Base plate part accommodating part
- 17:: Second contact accommodating cavity
- 17a:: Base plate part accommodating part
- 30:: First contact (contact)
- 31:: Base plate part
- 32:: Linking part
- 34:: First elastic contact arm
- 34c:: Contact part
- 34d:: Bevel
- 35:: Second elastic contact arm
- 35c:: Contact part
- 35d:: Bevel
- 35e:: Anti-slipping piece
- 40:: Second contact (contact)
- 41:: Base plate part
- 42:: Linking part
- 44:: First elastic contact arm
- 44c:: Contact part
- 44d:: Bevel
- 45:: Second elastic contact arm
- 45d:: Bevel
- 45e:: Anti-slipping piece
- 45c:: Contact part
- PKG:: IC package
- PCB:: Circuit board

### BEST MODE FOR CARRYING OUT THE INVENTION

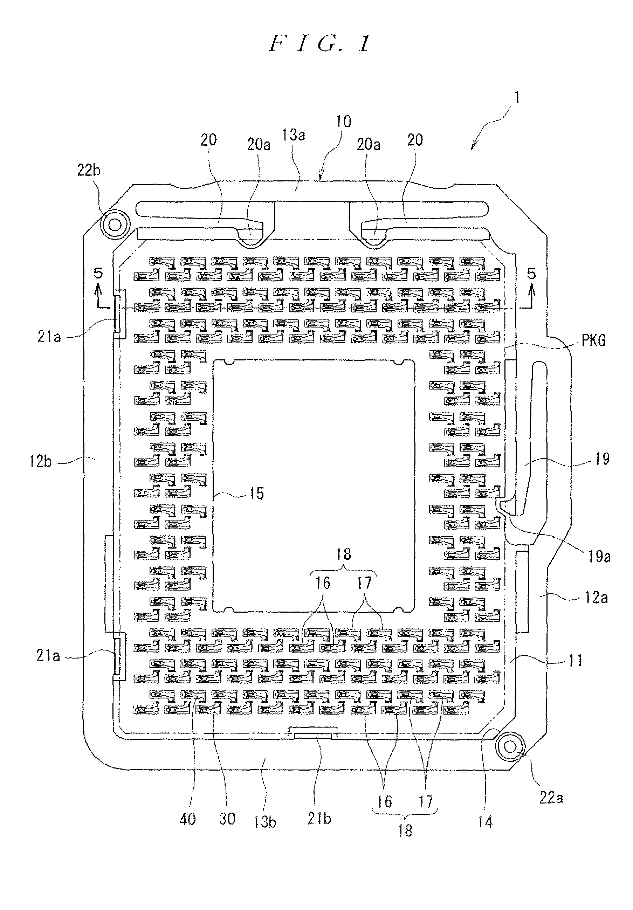

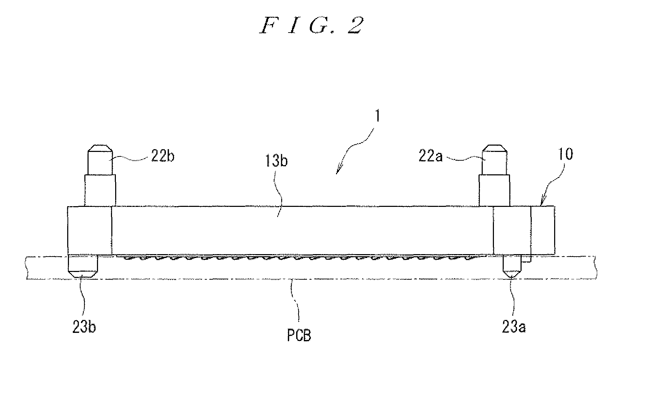

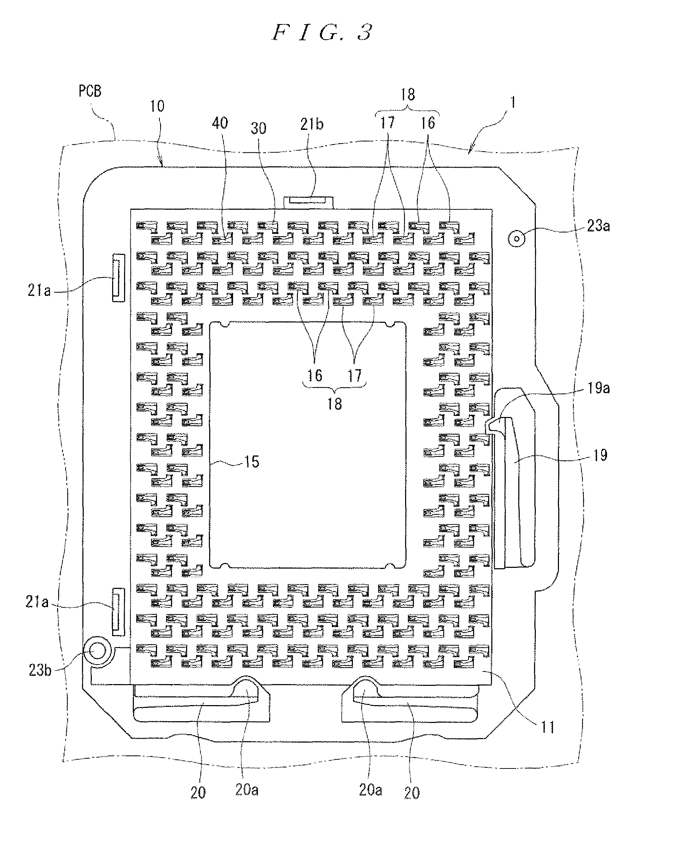

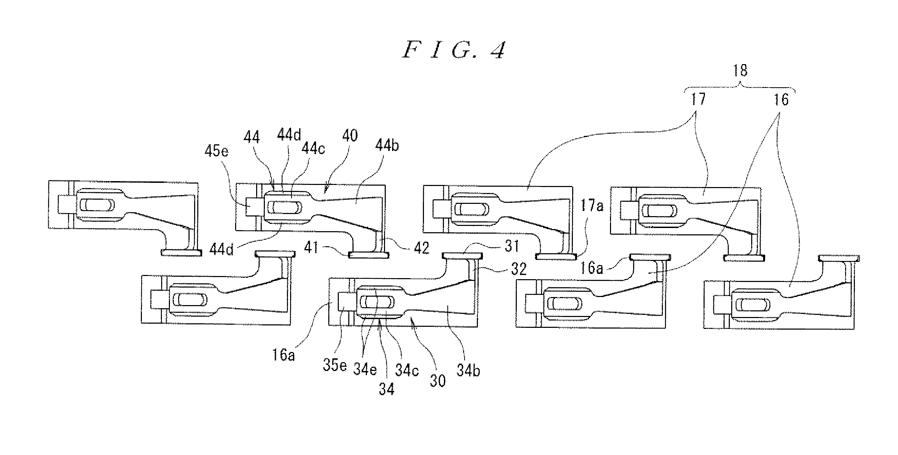

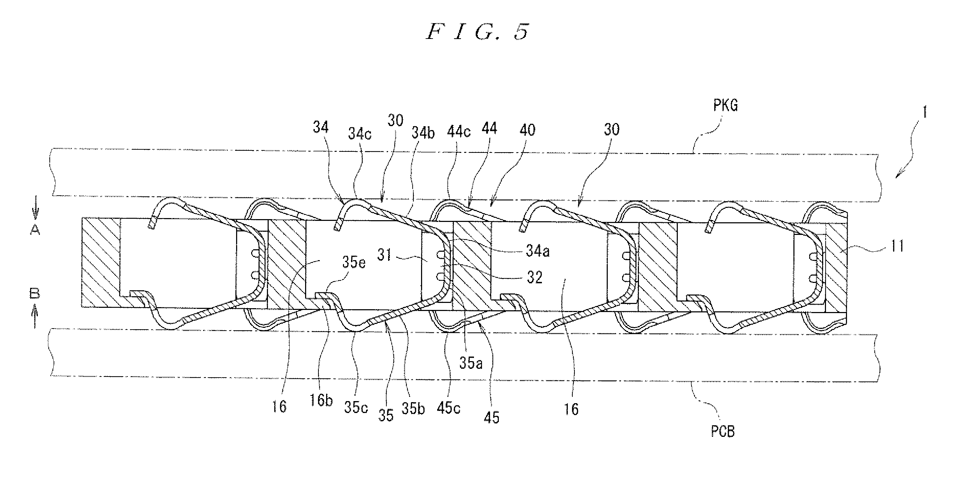

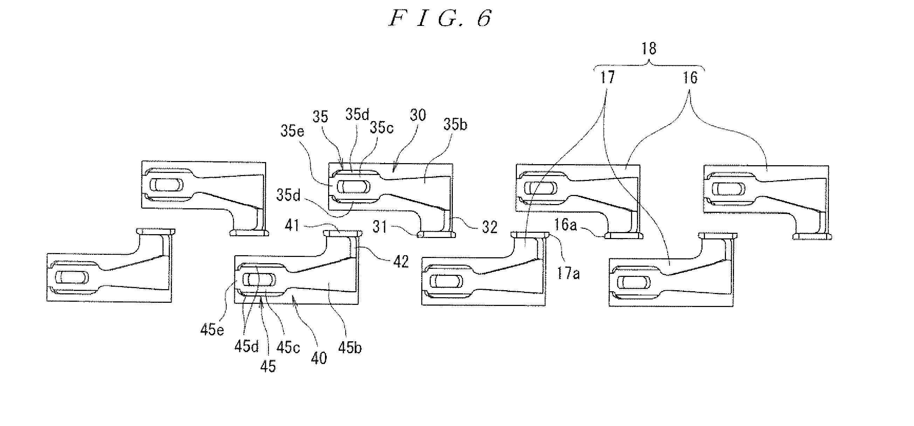

Next, an embodiment of the present invention will be described with reference to the figures. FIG. 1 is a plan view of the electrical connector of the present invention; in FIG. 1, however, an IC package is also shown by a one-dot chain line. FIG. 2 is a front view of the electrical connector of FIG. 1. FIG. 3 is a bottom view of the electrical connector of FIG. 1. In FIGS. 2 and 3, however, a circuit board is also shown by a one-dot chain line. FIG. 4 is a plan view showing a portion of a contact accommodating cavity row in FIG. 1. FIG. 5 is a sectional view along line 5-5 in FIG. 1. FIG. 6 is a bottom view showing a portion of a contact accommodating cavity row in FIG. 3.

In FIGS. 1 through 3, the electrical connector 1 comprises an insulating housing 10, and a plurality of first contacts 30 and a plurality of second contacts 40 that are secured to this housing 10.
Here, the housing 10 comprises a base part 11 that is formed in a substantially rectangular plate form, two side walls 12a and 12b that rise from both left and right edges of the base part 11 in the direction of width (left-right direction in FIG. 1), and end walls 13a and 13b that rise from both front and rear edges of the base part 11 in the direction of length (vertical direction in FIG. 1); the housing 10 is formed by molding an insulating resin. A rectangular opening 15 is formed in the central portion of the base part 11, and a plurality of contact accommodating cavity rows 18 are formed so as to surround the opening 15. As is shown in FIGS. 1 and 3, each of the contact accommodating cavity rows 18 is constructed from a plurality of first contact accommodating cavities 16 and a plurality of second contact accommodating cavities 17 that are disposed in a staggered arrangement along the direction of width of the base part 11, and a plurality of these contact accommodating cavity rows 18 are formed along the direction of length of the base part 11. Each of the first contact accommodating cavities 16 is designed to accommodate a first contact 30, and each of the second contact accommodating cavities 17 is designed to accommodate a second contact 40. Here, the first contact accommodating cavities 16 are disposed on the front side in the direction of length as seen in plan view (i.e., on the lower side in FIG. 1 and on the upper side in FIG. 3), and the second contact accommodating cavities 17 are disposed on the rear side in the direction of length as seen in plan view. Furthermore, as is shown in FIGS. 4 and 6, the first contact accommodating cavities 16 and second contact accommodating cavities 17 are disposed such that the base plate part accommodating parts 16a of the first contact accommodating cavities 16 and the base plate part accommodating parts 17a of the second contact accommodating cavities 17 are respectively aligned in a straight line in the direction of width of the base part 11. Moreover, the space surrounded by the two side walls 12a and 12b, two end walls 13a and 13b, and base part 11 forms a package accommodating space 14 that accommodates an IC package PKG. In addition, one first elastic arm 19 is provided on the side wall 12a located on the right side (right side in FIG. 1) in the direction of width as seen in plan view, and two second elastic arms 20 are provided on the rear side (upper side in FIG. 1) in the direction of length as seen in plan view. A projection 19a that contacts a side edge of the IC package PKG accommodated in the package accommodating space 14 and that pushes the IC package PKG toward the side wall 12b located on the opposite side of the side wall 12a on which the first elastic arm 19 is provided is disposed at the tip end of the first elastic arm 19. Furthermore, a projection 20a that contacts an end edge of the IC package PKG accommodated in the package accommodating space 14 and that pushes the IC package PKG toward the end wall 13b located on the opposite side of the end wall 13a on which the second elastic arms 20 are provided is disposed at the tip end of each of the second elastic arms 20. Moreover, two locking parts 21a that are locked on the upper surface of the IC package PKG accommodated in the package accommodating space 14 and that restrict the IC package PKG from flying out are provided on the side wall 12b located on the opposite side of the side wall 12a on which the first elastic arm 19 is provided. In addition, as is shown in FIG. 1, a first positioning post 22a is provided on the upper surface in the area where the side wall 12a on which the first elastic arm 19 is provided intersects with the end wall 13b, and a second positioning post 22b is provided on the upper surface in the area where the side wall 12b located on the opposite side of the side wall 12a intersects with the end wall 13a located on the opposite side of the end wall 13b. Furthermore, as is shown in FIGS. 2 and 3, a third positioning post 23a is provided on the undersurface of the base part 11 in the area substantially corresponding to the first positioning post 22a, and a fourth positioning post 23b is provided on the undersurface of the base part 11 in the area substantially corresponding to the second positioning post 22b.

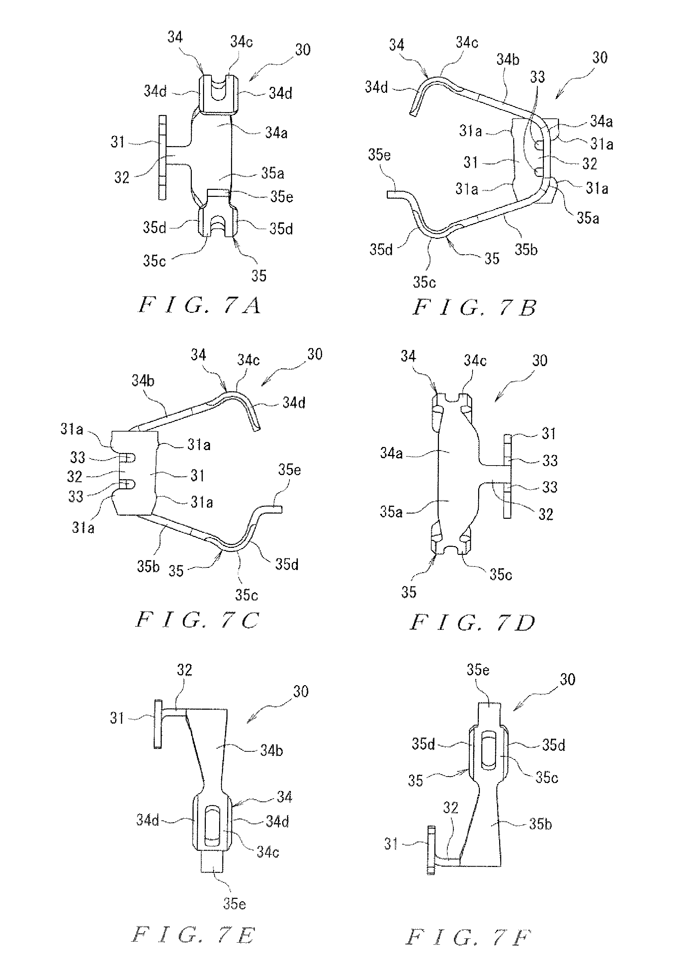

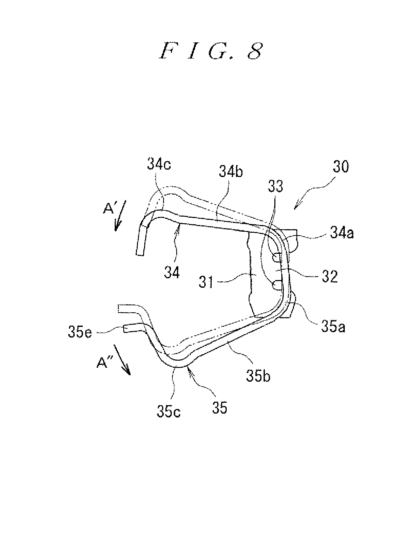

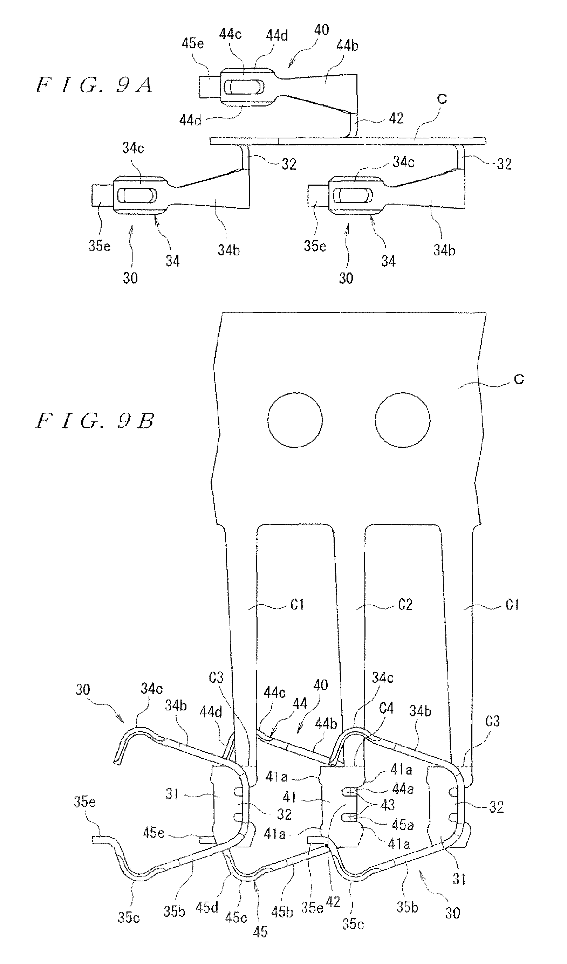

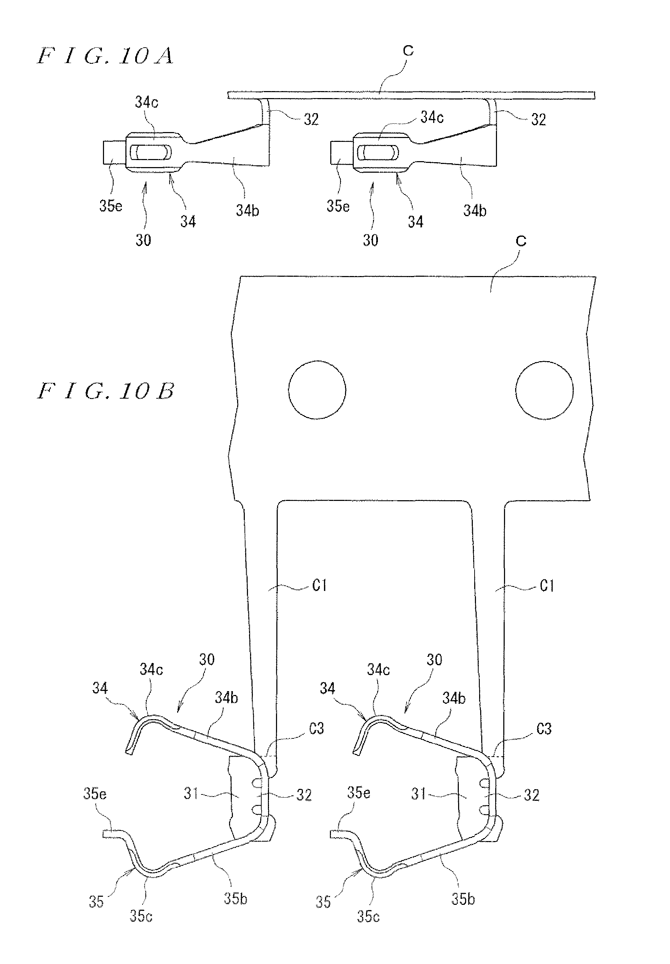

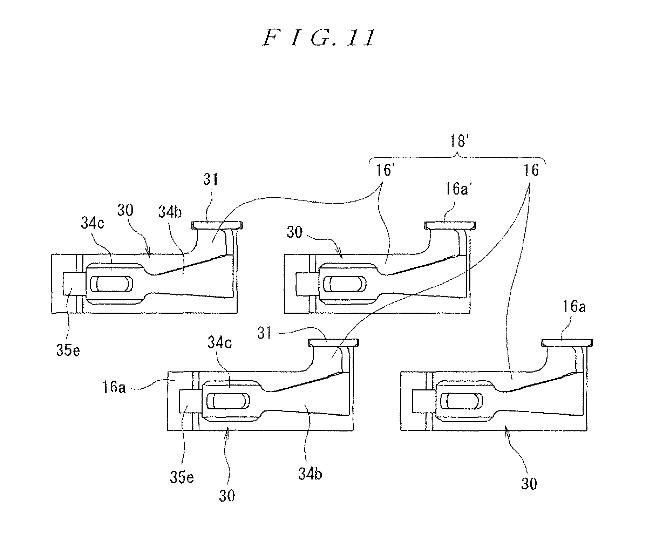

FIGS. 7A, 7B, 7C, 7D, 7E, and 7F show a first contact; FIG. 7A is a front view, FIG. 7B is a right side view, FIG. 7C is a left side view, FIG. 7D is a back view, FIG. 7E is a plan view, and FIG. 7F is a bottom view. FIG. 8 is an explanatory diagram showing the action of a first elastic contact arm and a second elastic contact arm in a case in which an external force is applied to the first elastic contact arm of a first contact. FIGS. 9A and 9B show a state in which the first contacts and second contacts are attached to a carrier; FIG. 9A is a plan view of first contacts and a second contact, and FIG. 9B is a side view of the first contacts and second contact. FIGS. 10A and 10B show a state in which the first contacts are attached to the carrier in a case in which the first contacts are arranged in a staggered fashion using only the first contacts; FIG. 10A is a plan view of first contacts, and FIG. 10B is a side view of the first contacts. FIG. 11 is a plan view showing a portion of a contact accommodating cavity row in a case in which the first contacts are arranged in a staggered fashion using only the first contacts shown in FIGS. 10A and 10B.

Each first contact 30 is formed by stamping and forming a metal plate, and comprises a substantially rectangular base plate part 31 that extends in the vertical direction as shown in FIGS. 7A, 7B, 7C, 7D, and 7E. A plurality of press-fitting parts 31a are formed so as to protrude from each of the two side edges of the base plate part 31 in the direction of width (in the direction of width of the base part 11, i.e., in the same direction as the left-right direction in FIG. 1) as shown in FIGS. 7B and 7C. This base plate part 31 is designed to be inserted into a first contact accommodating cavity 16 (i.e., the base plate part accommodating part 16a of the first contact accommodating cavity 16 described above) from above the housing 10, and to be press-fitted by the press-fitting parts 31a. Furthermore, as is shown in FIGS. 7B and 7C, a pair of cutouts 33 and 33 are formed in the right side edge of the base plate part 31 in the direction of width, separated by a specified distance in the vertical direction, and as is shown in FIGS. 7A, 7D, 7E, and 7F, the portion between these cutouts 33 and 33 is bent so as to extend in the forward direction that is perpendicular to the main surface of the base plate part 31 (forward in the direction of length of the base part 11, i.e., in the downward direction in FIG. 1); this portion constitutes a linking part 32. The position of the linking part 32 in the vertical direction is substantially the center of the base plate part 31 in the vertical direction. Moreover, the width of the linking part 32 is considerably smaller than the width of the base plate part 31 in the vertical direction. In addition, as is shown in FIG. 7B, a first elastic contact arm 34 that extends obliquely upward and leftward (toward the left of the base plate part 31¹ in the direction of width) from the tip end of the linking part 32, and a second elastic contact arm 35 that extends obliquely downward and leftward (toward the left of the base plate part 31 in the direction of width) from this tip end are provided at this tip end. The first elastic contact arm 34 comprises a base part 34a that extends upward from the tip end of the linking part 32 with the width being greater than the linking part 32, an elastic arm part 34b that is bent from the base part 34a and that extends obliquely upward and leftward, and a contact part 34c that is curved at the tip end of the elastic arm part 34b in an upward convex shape. As is shown in FIG. 5, in a state in which the base plate part 31 is press-fitted into a first contact accommodating cavity 16, the contact part 34c protrudes upward beyond the upper surface of the base part 11 of the housing 10, so that a conductive pad (not shown in the figures) of the IC package PKG contacts this contact part 34c. In addition, bevels 34d are applied to the corner portions of both side surfaces of the contact part 34c. Meanwhile, the second elastic contact arm 35 comprises a base part 35a that extends downward from the tip end of the linking part 32 with the width being greater than the linking part 32, an elastic arm part 35b that is bent from the base part 35a and that extends obliquely downward and leftward, a contact part 35c that is curved at the tip end of the elastic arm part 35b in a downward convex shape, and an anti-slipping piece 35e that extends in the leftward direction from the tip end of the contact part 35c. As is shown in FIG. 5, in a state in which the base plate part 31 is press-fitted into a first contact accommodating cavity 16, the contact part 35c protrudes downward beyond the undersurface of the base part 11 of the housing 10, so that a conductive pad (not shown in the figures) of the circuit board PCB contacts this contact part 35c. Furthermore, as is shown in FIG. 7F, bevels 35d are applied to the corner portions of both side surfaces of the contact part 35c. Moreover, as is shown in FIG. 5, in a state in which the first contacts 30 are respectively accommodated inside the first contact accommodating cavities 16, the anti-slipping pieces 35e respectively contact projections 16b provided on the base part 11 of the housing 10, so that the tip ends of the contact parts 35c are prevented from slipping out of the first contact accommodating cavities 16.

Meanwhile, each of the second contacts 40 is formed by stamping and forming a metal plate, and comprises a substantially rectangular base plate part 41 that extends in the vertical direction as shown in FIGS. 4, 6, 9A and 9B. A plurality of press-fitting parts 41a are formed so as to protrude from each of the two side edges of the base plate part 41 in the direction of width (in the direction of width of the base part 11, i.e., in the same direction as the left-right direction in FIG. 1) as shown in FIG. 9B. This base plate part 41 is designed to be inserted into the base plate part accommodating part 17a of a second contact accommodating cavity 17 from above the housing 10, and to be press-fitted by the press-fitting parts 41 a. Furthermore, as is shown in FIG. 9B, a pair of cutouts 43 and 43 are formed in the right side edge of the base plate part 41 in the direction of width, separated by a specified distance in the vertical direction, and as is shown in FIGS. 4 and 9A, the portion between these cutouts 43 and 43 is bent so as to extend in the rearward direction that is perpendicular to the main surface of the base plate part 41 (opposite direction of the linking part 32 and rearward in the direction of length of the base part 11, i.e., in the upward direction in FIG. 1); this portion constitutes a linking part 42. The position of the linking part 42 in the vertical direction is substantially the center of the base plate part 41 in the vertical direction. Moreover, the width of the linking part 42 is considerably smaller than the width of the base plate part 41 in the vertical direction. In addition, as is shown in FIG. 9B, a first elastic contact arm 44 that extends obliquely upward and leftward from the tip end of the linking part 42, and a second elastic contact arm 45 that extends obliquely downward and leftward from this tip end are provided at this tip end. The first elastic contact arm 44 comprises a base part 44a that extends upward from the tip end of the linking part 42 with the width being greater than the linking part 42, an elastic arm part 44b that is bent from the base part 44a and that extends obliquely upward and leftward, and a contact part 44c that is curved at the tip end of the elastic arm part 44b in an upward convex shape. As is shown in FIG. 5, in a state in which the base plate part 41 is press-fitted into a second contact accommodating cavity 17, the contact part 44c protrudes upward beyond the upper surface of the base part 11 of the housing 10, so that a conductive pad (not shown in the figures) of the IC package PKG contacts this contact part 44c. In addition, bevels 44d are applied to the corner portions of both side surfaces of the contact part 44c. Meanwhile, the second elastic contact arm 45 comprises a base part 45a that extends downward from the tip end of the linking part 42 with the width being greater than the linking part 42, an elastic arm part 45b that is bent from the base part 45a and that extends obliquely downward and leftward, a contact part 45c that is curved at the tip end of the elastic arm part 45b in a downward convex shape, and an anti-slipping piece 45e that extends in the leftward direction from the tip end of the contact part 45c. As is shown in FIG. 5, in a state in which the base plate part 41 is press-fitted into a second contact accommodating cavity 17, the contact part 45c protrudes downward beyond the undersurface of the base part 11 of the housing 10, so that a conductive pad (not shown in the figures) of the circuit board PCB contacts this contact part 45c. Furthermore, as is shown in FIG. 6, bevels 45d are applied to the corner portions of both side surfaces of the contact part 45c. Moreover, in a state in which the second contacts 40 are respectively accommodated inside the second contact accommodating cavities 17, the anti-slipping pieces 45e respectively contact projections (not shown in the figures) provided on the base part 11 of the housing 10, so that the tip ends of the contact parts 45c are prevented from slipping out of the second contact accommodating cavities 17.

Next, a method for manufacturing an electrical connector 1 will be described with reference to FIGS. 1, 4, 5, 9A, and 9B.
First, the housing 10 shown in FIG. 1 is prepared.
Next, as is shown in FIGS. 9A and 9B, carriers C are prepared for the number of the contact accommodating cavity rows 18, with each of these carriers C being a carrier C to which first contacts 30 of equal number to the first contact accommodating cavities 16 in each contact accommodating cavity row 18 are linked by contact linking pieces C 1 at the same pitch as the first contact accommodating cavities 16, and to which second contacts 40 of equal number to the second contact accommodating cavities 17 in the same contact accommodating cavity row 18 are linked by contact linking pieces C2 at the same pitch as the second contact accommodating cavities 17. These are manufactured by stamping and forming metal plates. In this state, the upper edges of the base plate parts 31 of the first contacts 30 are respectively linked to the contact linking pieces C1, while the upper edges of the base plate parts 41 of the second contacts 40 are respectively linked to the contact linking pieces C2, and the linking parts 32 of the first contacts 30 and the linking parts 42 of the second contacts 40 extend in opposite directions relative to each other from the base plate parts 31 and 41, respectively. Therefore, as is shown in FIG. 9A, a state is created in which the first elastic contact arms 34 and second elastic contact arms 35 of the first contacts 30 and the first elastic contact arms 44 and second elastic contact arms 45 of the second contacts 40 are arranged in a staggered fashion with respect to the corresponding carrier C as seen in plan view.

Then, in a state in which the first contacts 30 and second contacts 40 are linked to a carrier C, the base plate parts 31 of the first contacts 30 and the base plate parts 41 of the second contacts 40 are respectively inserted and press-fitted into the base plate part accommodating parts 16a of the first contact accommodating cavities 16 and the base plate part accommodating parts 17a of the second contact accommodating cavities 17 all at once from above the housing 10 as shown in FIGS. 4 and 5. That is, the press-fitting work of the contacts is performed once for each of the contact accommodating cavity rows 18. Next, the linking pieces C1 of the carrier C and the base plate parts 31 of the first contacts 30 are cut off at the cut lines C3 shown in FIG. 9B, and the linking pieces C2 of the carrier C and the base plate parts 41 of the second contacts 40 are cut off at the cut lines C4. Such a press-fitting and cutting work is performed for the number of times corresponding to the number of the contact accommodating cavity rows 18. As a result, an electrical connector 1 is completed.

Another conceivable method will be adduced below and compared with the invention of the present application.
Here, unlike a case in which first contacts 30 and second contacts 40 are used, and these first contacts 30 and second contacts 40 are arranged in a staggered fashion, a case in which only first contacts 30 are used, and these first contacts 30 are arranged in a staggered fashion will be described with reference to FIGS. 10A, 10B, and 11.
In this case, first, as is shown in FIG. 11, a housing is prepared which has a plurality of contact accommodating cavity rows 18' in which a plurality of first contact accommodating cavities 16 and a plurality of other first contact accommodating cavities 16' are disposed in a staggered arrangement such that the base plate part accommodating parts 16a of the first contact accommodating cavities 16 and the base plate part accommodating parts 16a' of the first contact accommodating cavities 16' are arranged in a staggered fashion.

Next, as is shown in FIGS. 10A and 10B, carriers C are prepared for two times the number of the contact accommodating cavity rows 18', with each of these carriers C being a carrier C to which first contacts 30 of equal number to the first contact accommodating cavities 16 in each contact accommodating cavity row 18' are linked by contact linking pieces C1 at the same pitch as the first contact accommodating cavities 16. These are manufactured by stamping and forming metal plates. In this state, as is shown in FIG. 10 A, the first elastic contact arms 34 of the first contacts 30 are arranged on one side of the corresponding carrier C as seen in plan view.

Then, in a state in which the first contacts 30 are linked to the corresponding carriers C, the base plate parts 31 of the first contacts 30 are respectively inserted and press-fitted into the base plate part accommodating parts 16a of the first contact accommodating cavities 16 as shown in FIG. 11. Next, the linking pieces C1 of the carriers C and the base plate parts 31 of the first contacts 30 are cut off at the cut lines C3 shown in FIG. 10B.
Furthermore, the base plate parts 31 of the first contacts 30 that are linked to the corresponding carriers C are similarly respectively inserted and press-fitted into the base plate part accommodating parts 16a' of the other first contact accommodating cavities 16'. Next, the linking pieces C 1 of the carriers C and the base plate parts 31 of the first contacts 30 are cut off at the cut lines C3. That is, the press-fitting work of the contacts is performed twice for each of the contact accommodating cavity rows 18'.

Then, such a work of press-fitting and cutting the base plate parts 31 of the first contacts 30 is performed for the number of times corresponding to the number of the contact accommodating cavity rows 18'.
Thus, in a case in which only the first contacts 30 are used, and these first contacts 30 are arranged in a staggered fashion, the press-fitting work of the contacts is performed twice for each of the contact accommodating cavity rows 18', whereas in a case in which the first contacts 30 and second contacts 40 are used, and these first contacts 30 and second contacts 40 are arranged in a staggered fashion, the press-fitting work of the contacts is performed only once for each of the contact accommodating cavity rows 18. Accordingly, in a case in which the first contacts 30 and second contacts 40 are used, and these first contacts 30 and second contacts 40 are arranged in a staggered fashion as in the present embodiment, there is the merit of facilitating and simplifying the press-fitting work of the contacts.

Moreover, in the case of the present embodiment, the linking parts 32 of the first contacts 30 and the linking parts 42 of the second contacts 40 extend in opposite directions relative to each other from the base plate parts 31 and 41, respectively. Therefore, the first elastic contact arms 34 and second elastic contact arms 35 of the first contacts 30 and the first elastic contact arms 44 and second elastic contact arms 45 of the second contacts 40 can be arranged in a staggered fashion with respect to the corresponding carrier C, so that the material for the first contacts 30 and second contacts 40 can be obtained in a favorable manner.

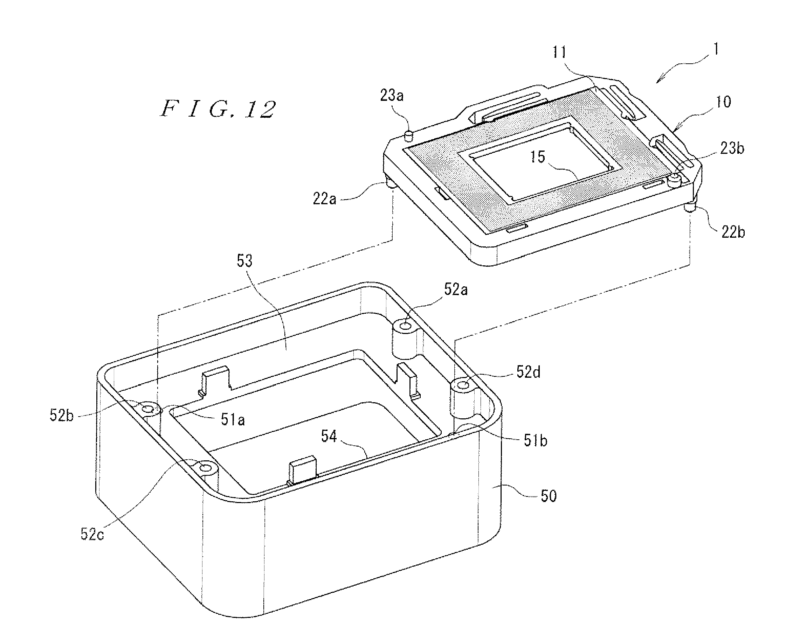

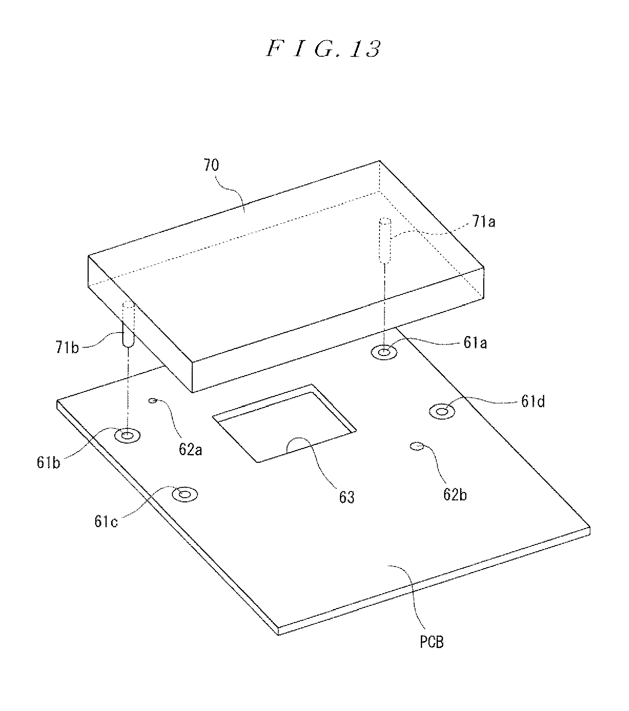

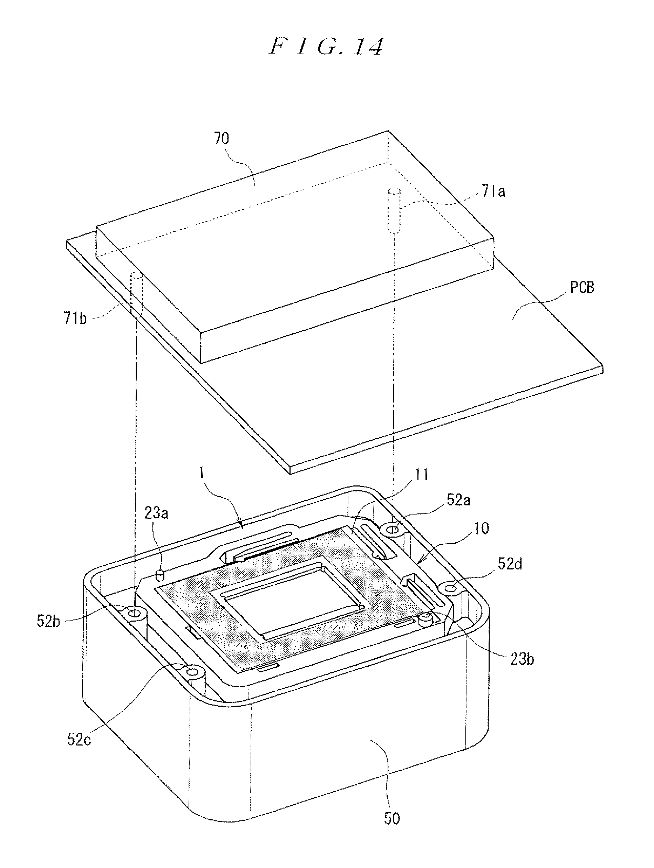

Next, a method for electrically connecting an IC package PKG and a circuit board PCB to each other by means of an electrical connector 1 will be described. FIG. 12 is a perspective view used to illustrate a method for mounting an electrical connector accommodating an IC package in the housing of an optical engine. FIG. 13 is a perspective view used to illustrate a method for attaching a jig to a circuit board. FIG. 14 is a perspective view used to illustrate a method for mounting the circuit board on the housing of the optical engine using the jig attached to the circuit board. First, as is shown in FIGS. 1 and 5, the IC package PKG is accommodated in the package accommodating space 14 of the electrical connector 1 in the direction of arrow A from the upper side of the electrical connector 1. In this case, the projection 19a of the first elastic arm 19 contacts a side edge of the IC package PKG, and pushes the IC package PKG toward the side wall 12b located on the opposite side of the side wall 12a on which the first elastic arm 19 is provided; furthermore, the projections 20a of the second elastic arms 20 contact an end edge of the IC package PKG, and push the IC package PKG toward the end wall 13b located on the opposite side of the end wall 13a on which the second elastic arms 20 are provided. Then, the locking parts 21a provided on the side wall 12b are locked on the upper surface of the IC package PKG, and restrict the IC package PKG from flying out.

Moreover, when the IC package PKG is accommodated in the package accommodating space 14 of the electrical connector 1 in the direction of arrow A from the upper side of the electrical connector 1, the conductive pads (not shown in the figures) provided on the IC package PKG come into contact with the contact parts 34c of the first elastic contact arms 34 of the first contacts 30 and the contact parts 44c of the first elastic contact arms 44 of the second contacts 40, and these conductive pads press the contact parts 34c and contact parts 44c. Therefore, as is shown in FIG. 8 (only a first contact 30 is shown in FIG. 8), the first elastic contact arms 34 of the first contacts 30 and the first elastic contact arms 44 of the second contacts 40 are elastically deformed downward (in the direction of arrow A' in FIG. 8), so that the contact parts 34c of the first elastic contact arms 34 of the first contacts 30 and the contact parts 44c of the first elastic contact arms 44 of the second contacts 40 are displaced downward. In FIG. 8, the manner in which the contact parts 34c are displaced downward is indicated by a solid line moved from a chain line. When the contact parts 34c and contact parts 44c are displaced downward, the linking parts 32 that are linked to the first elastic contact arms 34 and second elastic contact arms 35 of the first contacts 30 and the linking parts 42 that are linked to the first elastic contact arms 44 and second elastic contact arms 45 of the second contacts 40 respectively undergo elastic deformation with forces smaller than the pressing forces applied to the contact parts 34c and contact parts 44c, so that the pressing forces applied to the contact parts 34c of the first elastic contact arms 34 and the contact parts 44c of the first elastic contact arms 44 on one side are respectively transmitted to the contact parts 35c of the second elastic contact arms 35 and the contact parts 45c of the second elastic contact arms 45 on the other side. The pressing forces transmitted to the contact parts 35c and 45c are approximately 1/2 to 3/5 of the pressing forces given to the contact parts 34c and 44c. As a result, the contact parts 35c of the second elastic contact arms 35 of the first contacts 30 and the contact parts 45c of the second elastic contact arms 45 of the second contacts 40 are displaced downward (in the direction of arrow A" in FIG. 8).

Then, the electrical connector 1 accommodating the IC package PKG is mounted in the housing 50 of an optical engine as shown in FIG. 12. The housing 50 is formed in a substantially rectangular shape, and a connector accommodating space 53 is formed in the upper surface of this housing 50. In the bottom portion of this connector accommodating space 53, furthermore, an opening 54 is formed substantially in the central portion, and a first positioning post receiving hole 51a that receives the first positioning post 22a and a second positioning post receiving hole 51b that receives the second positioning post 22b are formed. Furthermore, four screw holes 52a, 52b, 52c, and 52d are formed in the vicinity of the four corners of the bottom portion of the connector accommodating space 53.

When the electrical connector 1 is to be mounted, the electrical connector 1 is turned over such that the IC package PKG is on the bottom as shown in FIG. 12, and the first positioning post 22a is inserted into the first positioning post receiving hole 51a, while the second positioning post 22b is inserted into the second positioning post receiving hole 51b.
In this state, the contact parts 35c of the second elastic contact arms 35 of the first contacts 30 and the contact parts 45c of the second elastic contact arms 45 of the second contacts 40 protrude upward from the upper surface (this is originally the undersurface, but it has become the upper surface because the electrical connector 1 is turned over) of the base part 11 of the electrical connector 1.

Next, as is shown in FIG. 13, a jig 70 is mounted on the circuit board PCB. Here, the circuit board PCB is formed in a rectangular shape, and screw through-holes 61a, 61b, 61c, and 61d are formed in positions respectively corresponding to the screw holes 52a, 52b, 52c, and 52d in the housing 50. Moreover, an opening 63 is formed in the circuit board PCB in a position corresponding to the opening 54 in the housing 50, and a third positioning post receiving hole 62a and a fourth positioning post receiving hole 62b are formed in positions respectively corresponding to the third positioning post 23a and fourth positioning post 23b of the electrical connector 1 mounted in the housing 50. Meanwhile, the jig 70 is formed in a substantially rectangular shape, and positioning posts 71 a and 71b that can be respectively inserted into the screw through-holes 61a and 61b are formed in a protruding manner.

In the mounting of the jig 70, the positioning posts 71a and 71b of the jig 70 are respectively inserted into the screw through-holes 61a and 61b in the circuit board PCB.
Then, as is shown in FIG. 14, the circuit board PCB is mounted on the housing 50 of the optical engine using the jig 70 that is attached to the circuit board PCB. Specifically, the positioning posts 71a and 71b of the jig 70 are respectively inserted into the screw holes 52a and 52b in the housing 50, and the third positioning post 23a and fourth positioning post 23b of the electrical connector 1 are respectively inserted into the third positioning post receiving hole 62a and fourth positioning post receiving hole 62b in the circuit board PCB. As a result, the circuit board PCB is positioned with respect to the electrical connector 1. Then, the jig 70 is removed, and attachment screws (not shown in the figures) are respectively passed through the screw through-holes 61a, 61b, 61c, and 61d in the circuit board PCB, and are respectively engaged with the screw holes 52a, 52b, 52c, and 52d in the housing 50. As a result, the circuit board PCB is mounted on the housing 50 of the optical engine, and the IC package PKG is electrically connected to the circuit board PCB in a secure manner.

Here, when the circuit board PCB is mounted on the housing 50, the conductive pads (not shown in the figures) provided on the circuit board PCB contact the contact parts 35c of the second elastic contact arms 35 of the first contacts 30 and the contact parts 45c of the second elastic contact arms 45 of the second contacts 40, and these conductive pads press the contact parts 35c and contact parts 45c, so that the second elastic contact arms 35 of the first contacts 30 and the second elastic contact arms 45 of the second contacts 40 are elastically deformed downward (in the direction opposite from the direction of arrow A" in FIG. 8). Furthermore, the contact parts 35c of the second elastic contact arms 35 of the first contacts 30 and the contact parts 45c of the second elastic contact arms 45 of the second contacts 40 are displaced downward. When the contact parts 35c and contact parts 45c are displaced downward, the linking parts 32 that are linked to the first elastic contact arms 34 and second elastic contact arms 35 of the first contacts 30 and the linking parts 42 that are linked to the first elastic contact arms 44 and second elastic contact arms 45 of the second contacts 40 respectively undergo elastic deformation with forces smaller than the pressing forces applied to the contact parts 35c and contact parts 45c, so that the pressing forces applied to the contact parts 35c of the second elastic contact arms 35 and the contact parts 45c of the second elastic contact arms 45 on one side are respectively transmitted to the contact parts 34c of the first elastic contact arms 34 and the contact parts 44c of the first elastic contact arms 44 on the other side. As a result, the contact parts 34c of the first elastic contact arms 34 of the first contacts 30 and the contact parts 44c of the first elastic contact arms 44 of the second contacts 40 are displaced downward.

Therefore, even in cases where the IC package PKG or circuit board PCB is warped or deformed for some reason, when the conductive pads provided on the IC package PKG contact and press the contact parts 34c of the first elastic contact arms 34 of the first contacts 30 and the contact parts 44c of the first elastic contact arms 44 of the second contacts 40, and the conductive pads provided on the circuit board PCB contact and press the contact parts 35c of the second elastic contact arms 35 of the first contacts 30 and the contact parts 45c of the second elastic contact arms 45 of the second contacts 40, the linking parts 32 and 42 respectively undergo elastic deformation with forces smaller than the pressing forces of these conductive pads, so that the pressing forces applied to the contact parts 34c and 44c or contact parts 35c and 45c on one side are respectively transmitted to the contact parts 35c and 45c or contact parts 34c and 44c on the other side. Accordingly, desired amounts of flexing of the first elastic contact arms 34 and 44 and second elastic contact arms 35 and 45 in the vertical direction are obtained, and desired amounts of elastic force of these first elastic contact arms 34 and 44 and second elastic contact arms 35 and 45 are obtained as a result, so that appropriate amounts of contact pressure are imparted to the contact parts 34c and 44c of the first elastic contact arms 34 and 44 and the contact parts 35c and 45c of the second elastic contact arms 35 and 45. Consequently, it is possible to increase the contact reliability of the contact parts 34c and 44c of the first elastic contact arms 34 and 44 that contact the conductive pads of the IC package PKG and the contact parts 35c and 45c of the second elastic contact arms 35 and 45 that contact the conductive pads of the circuit board PCB.

Furthermore, the bevels 35d and 45d are respectively applied to the corner portions of the two side surfaces of the contact parts 35c of the second elastic contact arms 35 of the first contacts 30 and the corner portions of the two side surfaces of the contact parts 45c of the second elastic contact arms 45 of the second contacts 40. Therefore, when the conductive pads provided on the circuit board PCB contact the contact parts 35c and 45c of the second elastic contact arms 35 and 45, the portions of the bevels 35d and 45d that are respectively applied to the corner portions of the two side surfaces of the contact parts 35c and 45c of the second elastic contact arms 35 and 45 can prevent the contact parts 35c and 45c and the conductive pads from catching each other in cases where the circuit board PCB is rotated or slid, and an external force is applied to the contact parts 35c and 45c from these conductive pads. Because the conductive pads protrude slightly from the main surface of the circuit board PCB, these conductive pads tend to be caught by the contact parts 35c of the second elastic contact arms 35 of the first contacts 30 and the contact parts 45c of the second elastic contact arms 45 of the second contacts 40.

Meanwhile, on the side of the first elastic contact arms 34 and 44, when the IC package PKG is accommodated in the package accommodating space 14 of the electrical connector 1, the projection 19a of the first elastic arm 19 is designed to contact a side edge of the IC package PKG, and to push the IC package PKG toward the side wall 12b located on the opposite side of the side wall 12a on which the first elastic arm 19 is provided, and the projections 20a of the second elastic arms 20 are designed to contact an end edge of the IC package PKG, and to push the IC package PKG toward the end wall 13b located on the opposite side of the end wall 13a on which the second elastic arms 20 are provided. Therefore, there is no danger that an external force will be applied to the contact parts 34c and 44c from the conductive pads of the IC package PKG because of the IC package PKG being rotated or slid. However, even in the case of a construction in which the IC package PKG can be rotated or slid, because the bevels 34d and 44d are also respectively applied to the corner portions of the two side surfaces of the contact parts 34c of the first elastic contact arms 34 of the first contacts 30 and the corner portions of the two side surfaces of the contact parts 44c of the first elastic contact arms 44 of the second contacts 40, it is possible to prevent the contact parts 34c and 44c and the conductive pads from catching each other. Because the conductive pads protrude slightly from the main surface of the IC package PKG, these conductive pads tend to be caught by the contact parts 34c of the first elastic contact arms 34 of the first contacts 30 and the contact parts 44c of the first elastic contact arms 44 of the second contacts 40.

Furthermore, anti-slipping pieces 35e are respectively provided at the tip ends of the contact parts 35c of the second elastic contact arms 35 of the first contacts 30, with these anti-slipping pieces 35e preventing the tip ends of these contact parts 35c from slipping out of the first contact accommodating cavities 16 by contacting the projections 16b provided on the base part 11 of the housing 10. Moreover, anti-slipping pieces 45e are respectively provided at the tip ends of the contact parts 45c of the second elastic contact arms 45 of the second contacts 40, with these anti-slipping pieces 45e preventing the tip ends of these contact parts 45c from slipping out of the second contact accommodating cavities 17 by contacting the projections (not shown in the figures) provided on the base part 11 of the housing 10. As a result, even in cases where an external force is applied to the contact parts 35c and 45c from the conductive pads because of the circuit board PCB being rotated or slid when the conductive pads provided on the circuit board PCB contact the contact parts 35c and 45c of the second elastic contact arms 35 and 45, the anti-slipping pieces 35e and 45e can respectively prevent the tip ends of the contact parts 35c and 45c from slipping out of the contact accommodating cavities 16 and 17 by contacting the projections 16b (not shown in the figures) of the housing 10, thus preventing the deformation of the second elastic contact arms 35 and 45.

Incidentally, no anti-slipping piece is provided at the tip ends of the contact parts 34c of the first elastic contact arms 34 of the first contacts 30 or at the tip ends of the contact parts 44c of the first elastic contact arms 44 of the second contacts 40. This is because there is little risk of the IC package PKG being rotated or slid when the conductive pads provided on the IC package PKG contact the contact parts 34c and 44c of the first elastic contact arms 34 and 44.
An embodiment of the present invention has been described above. However, the present invention is not limited to this embodiment, and various alterations and modifications can be made.

For example, with regard to the first contacts 30, bevels 34d and 35d are respectively applied to the corner portions of the two side surfaces of the contact parts 34c of the first elastic contact arms 34 and the corner portions of the two side surfaces of the contact parts 35c of the second elastic contact arms 35. However, it would also be possible to apply bevels 34d only to the corner portions of the two side surfaces of the contact parts 34c of the first elastic contact arms 34, or apply bevels 35d only to the corner portions of the two side surfaces of the contact parts 35c of the second elastic contact arms 35. For instance, it would be effective to apply bevels 34d only to the corner portions of the two side surfaces of the contact parts 34c of the first elastic contact arms 34 when only the IC package PKG is made to be rotatable or slidable, and to apply bevels 35d only to the corner portions of the two side surfaces of the contact parts 35c of the second elastic contact arms 35 when only the circuit board PCB is made to be rotatable or slidable.

Furthermore, with regard to the second contacts 40, bevels 44d and 45d are respectively applied to the corner portions of the two side surfaces of the contact parts 44c of the first elastic contact arms 44 and the corner portions of the two side surfaces of the contact parts 45c of the second elastic contact arms 45. However, it would also be possible to apply bevels 44d only to the corner portions of the two side surfaces of the contact parts 44c of the first elastic contact arms 44, or apply bevels 45d only to the corner portions of the two side surfaces of the contact parts 45c of the second elastic contact arms 45. For instance, it would be effective to apply bevels 44d only to the corner portions of the two side surfaces of the contact parts 44c of the first elastic contact arms 44 when only the IC package PKG is made to be rotatable or slidable, and to apply bevels 45d only to the corner portions of the two side surfaces of the contact parts 45c of the second elastic contact arms 45 when only the circuit board PCB is made to be rotatable or slidable.

Moreover, in the first contacts 30, anti-slipping pieces 35e are respectively provided only at the tip ends of the contact parts 35c of the second elastic contact arms 35. However, anti-slipping pieces may be provided only at the tip ends of the contact parts 34c of the first elastic contact arms 34, or anti-slipping pieces may also be provided both at the tip ends of the contact parts 34c of the first elastic contact arms 34 and at the tip ends of the contact parts 35c of the second elastic contact arms 35. For example, it would be effective to provide anti-slipping pieces only at the tip ends of the contact parts 34c of the first elastic contact arms 34 when only the IC package PKG is made to be rotatable or slidable, and to provide anti-slipping pieces both at the tip ends of the contact parts 34c of the first elastic contact arms 34 and at the tip ends of the contact parts 35c of the second elastic contact arms 35 when both the IC package PKG and circuit board PCB are made to be rotatable or slidable.

In addition, in the second contacts 40, anti-slipping pieces 45e are respectively provided only at the tip ends of the contact parts 45c of the second elastic contact arms 45. However, anti-slipping pieces may be provided only at the tip ends of the contact parts 44c of the first elastic contact arms 44, or anti-slipping pieces may also be provided both at the tip ends of the contact parts 44c of the first elastic contact arms 44 and at the tip ends of the contact parts 45c of the second elastic contact arms 45. For example, it would be effective to provide anti-slipping pieces only at the tip ends of the contact parts 44c of the first elastic contact arms 44 when only the IC package PKG is made to be rotatable or slidable, and to provide anti-slipping pieces both at the tip ends of the contact parts 44c of the first elastic contact arms 44 and at the tip ends of the contact parts 45c of the second elastic contact arms 45 when both the IC package PKG and circuit board PCB are made to be rotatable or slidable.

Furthermore, the linking parts 32 in the first contacts 30 respectively extend in the direction perpendicular to the main surfaces of the base plate parts 31. However, as long as these linking parts 32 extend in a direction that respectively intersects with the main surfaces of the base plate parts 31, this direction is not necessarily limited to the perpendicular direction. Moreover, the linking parts 42 in the second contacts 40 also respectively extend in the direction perpendicular to the main surfaces of the base plate parts 41. However, as long as the linking parts 42 extend in the opposite direction of the linking parts 32, this direction is not necessarily limited to the perpendicular direction.

## Claims

1. A contact comprising:
a substantially rectangular base plate part that extends in the vertical direction and that is secured to a contact accommodating cavity in a housing;
a linking part that extends from the base plate part in a direction intersecting with the main surface of the base plate part;
a first elastic contact arm that extends obliquely upward from the tip end of the linking part and that has a contact part which contacts a conductive pad on an IC package; and
a second elastic contact arm that extends obliquely downward from the tip end of the linking part and that has a contact part which contacts a conductive pad on a circuit board.

2. The contact according to Claim 1, wherein bevels are applied to the corner portions of the two side surfaces of the contact part of the first elastic contact arm and/or the corner portions of the two side surfaces of the contact part of the second elastic contact arm.

3. The contact according to Claim 1 or 2, wherein an anti-slipping piece that prevents the tip end of the contact part from slipping out of the contact accommodating cavity by contacting the housing is provided at the tip end of the contact part of the first elastic contact arm and/or the contact part of the second elastic contact arm.

4. An electrical connector comprising:
a housing in which a plurality of first contact accommodating cavities and a plurality of second contact accommodating cavities are disposed in a staggered arrangement such that the base plate part accommodating parts of the first contact accommodating cavities and the base plate part accommodating parts of the second contact accommodating cavities are aligned in a straight line;
a plurality of first contacts each of which comprises a substantially rectangular base plate part that extends in the vertical direction and that is secured to the base plate part accommodating part of one of the first contact accommodating cavities, a linking part that extends from the base plate part in a direction intersecting with the main surface of the base plate part, a first elastic contact arm that extends obliquely upward from the tip end of this linking part and that has a contact part which contacts a conductive pad on an IC package, and a second elastic contact arm that extends obliquely downward from the tip end of the linking part and that has a contact part which contacts a conductive pad on a circuit board; and
a plurality of second contacts each of which comprises a substantially rectangular base plate part that extends in the vertical direction and that is secured to the base plate part accommodating part of one of the second contact accommodating cavities, a linking part that extends from the base plate part in the direction opposite from the direction intersecting with the main surface of the base plate part of a first contact, a first elastic contact arm that extends obliquely upward from the tip end of this linking part and that has a contact part which contacts a conductive pad on the IC package, and a second elastic contact arm that extends obliquely downward from the tip end of the linking part and that has a contact part which contacts a conductive pad on the circuit board.

5. The electrical connector according to Claim 4, wherein bevels are respectively applied to the corner portions of the two side surfaces of the contact parts of the first elastic contact arms and/or the corner portions of the two side surfaces of the contact parts of the second elastic contact arms of the first contacts, and bevels are respectively applied to the corner portions of the two side surfaces of the contact parts of the first elastic contact arms and/or the corner portions of the two side surfaces of the contact parts of the second elastic contact arms of the second contacts.

6. The electrical connector according to Claim 4 or 5, wherein anti-slipping pieces are respectively provided at the tip ends of the contact parts of the first elastic contact arms and/or the contact parts of the second elastic contact arms of the first contacts, with these anti-slipping pieces preventing these tip ends from slipping out of the first contact accommodating cavities by contacting the housing, and anti-slipping pieces are respectively provided at the tip ends of the contact parts of the first elastic contact arms and/or the contact parts of the second elastic contact arms of the second contacts, with these anti-slipping pieces preventing these tip ends from slipping out of the second contact accommodating cavities by contacting the housing.
